# EUROPEAN PATENT APPLICATION

(11) **EP 4 726 893 A1**
(43) Date of publication of application: **15.04.2026**
(21) Application number: 25202534.1
(22) Date of filing: 16.09.2025
(51) Int. Cl.: H01M 50/293, H01M 10/48, H01M 50/242, H10N 30/85, H10N 30/857, H10N 30/00, H10N 30/20, H01M 50/209, H01M 50/291

(54) **SECONDARY BATTERY MODULE**

(30) Priority: 11.10.2024 KR 20240138093
(71) Applicant: SAMSUNG SDI CO., LTD., Yongin-si, Gyeonggi-do 17084 (KR)
(72) Inventor: BAEK, Soo Min, 16678 Suwon-si (KR)
(74) Representative: Marks & Clerk LLP

(57) **Abstract**

The present disclosure relates to a secondary battery module and is directed to providing a secondary battery module capable of maintaining a physically stable structure even when a secondary battery deforms. The secondary battery module includes a plurality of secondary batteries arranged in a first direction, and a partition member positioned in a gap between two adjacent secondary batteries among the plurality of secondary batteries. The partition member has a variable length at least in the first direction in response to an electrical signal applied to the partition member.

## Description

### BACKGROUND

### Technical Field

The present disclosure relates to a secondary battery module.

### Description of the Related Art

Unlike a primary battery that cannot be recharged, a secondary battery is a battery that can be recharged and discharged. Low-capacity secondary batteries may be used for portable small-sized electronic devices, such as smartphones, feature phones, notebook computers, digital cameras, and camcorders. High-capacity secondary batteries are widely used as power sources for driving a motor in hybrid vehicles or electric vehicles and a power storage battery. A secondary battery includes a positive electrode and/or a negative electrode, an electrode assembly including the electrodes, a case that accommodates the electrode assembly, electrode terminals connected to the electrode assembly, and the like.

As technology advances, secondary batteries with high capacity are required. Accordingly, a plurality of secondary batteries may be electrically connected and used together. For example, the secondary battery may be used in an electronic device in the form of a battery module including a plurality of secondary batteries, and/or a battery pack including a plurality of secondary battery modules. A secondary battery pack is also configured by a plurality of secondary batteries. Thus, secondary batteries can be used together in an electronic device that requires high power and/or high capacity, such as an electric vehicle or the like.

A secondary battery module or secondary battery pack has a plurality of secondary batteries arranged in at least one direction in the housing. The secondary batteries may be disposed adjacent to each other or spaced apart by a predetermined gap.

The above information disclosed is merely intended to improve understanding of the background of the present disclosure and thus may include information that does not constitute related art.

### SUMMARY

The present disclosure is directed to providing a secondary battery module capable of maintaining a physically stable structure even when a secondary battery undergoes deformation.

The present disclosure is also directed to providing a secondary battery module capable of absorbing expansion of a secondary battery to prevent damage to a module structure.

However, the problems to be solved by the present disclosure are not limited to the above-mentioned problems, and other problems not mentioned can be clearly understood by those skilled in the art from the following description.

According to an aspect of the present disclosure, there is provided a secondary battery module including a plurality of secondary batteries arranged in a first direction, and a partition member positioned in a gap between two adjacent secondary batteries among the plurality of secondary batteries, the partition member having a variable length at least in the first direction in response to an electrical signal applied to the partition member.

According to one aspect of the embodiment, the length of the partition member may be variable at least in the first direction according to a magnitude of a voltage of the electrical signal applied to the partition member. For example, the partition member may include one or more electrically variable members each having a variable length at least in the first direction according to the magnitude of the voltage, and electrode members configured to apply the voltage to the electrically variable members.

In this case, the electrically variable members may be configured to change in shape according to the magnitude of the voltage, and the electrode members may be positioned on outer sides of each of the electrically variable members in the first direction. As an example, the electrically variable member may be formed of a piezoelectric material or an electroactive polymer material. As another example, the electrode members may each be formed of a metallic material having a melting point higher than a melting point of a material of a case of each of the secondary batteries. As still another example, the partition member may further include insulating members positioned on outer sides of the pair of electrode members in the first direction. The pair of insulating members may each be formed of a material that includes one or more of alumina, mica, and silicone gel.

According to another aspect of the embodiment, the secondary battery module may further include a sensor configured to detect whether at least one of the plurality of secondary batteries is swollen, wherein the electrical signal may be applied to the partition member based on a detection result of the sensor.

As an example, the secondary battery module may further include a power supply configured to generate the electrical signal and apply the electrical signal to the partition member, wherein the sensor is configured to estimate an extent of swelling based on at least one of a state of charge and a number of charge-discharge cycles of the at least one of the secondary batteries, the power supply is configured to generate the electrical signal with a magnitude corresponding to the estimated extent of the swelling, and the variable length of the partition member may be variable in the first direction according to the magnitude of the electrical signal applied to the partition member.

As another example, the secondary battery may further include a power supply configured to generate the electrical signal and apply the electrical signal to the partition member, wherein the sensor is configured to determine an extent of swelling based on a size of the at least one of the secondary batteries in the first direction, the power supply is configured to generate the electrical signal with a magnitude corresponding to the determined extent of swelling, and the variable length of the partition member is variable in the first direction according to the magnitude of the electrical signal applied to the partition member.

According to another aspect of the present disclosure, there is provided a secondary battery module including a plurality of secondary batteries arranged in a first direction, and a partition member positioned in a gap between two adjacent secondary batteries among the plurality of secondary batteries, the partition having a variable thickness in response to an electrical signal applied to the partition member, wherein the partition member may include an electrically variable element configured to change in size at least in the first direction according to a magnitude of the electrical signal, electrode plates positioned on outer sides of the electrically variable element in the first direction, and configured to apply the electrical signal to the electrically variable element, and insulating plates positioned on outer sides of the electrode plates in the first direction.

According to one aspect of the embodiment, the electrically variable element may include one or more of a piezoelectric element and an electroactive polymer element.

According to another aspect of the embodiment, the electrically variable element may be sheet with a thickness in the first direction.

According to still another aspect of the embodiment, the electrically variable element may include a plurality of electrically variable elements, and the electrically variable elements may be spaced from each other in a plane that is parallel to the electrode plate.

According to yet another aspect of the embodiment, the electrode plates may each be formed of a metallic material having a melting point higher than a melting point of a material of a case of each of the secondary batteries.

According to yet another aspect of the embodiment, the insulating plates may be formed of a material that includes one or more of alumina, mica, and silicone gel.

According to yet another aspect of the embodiment, the secondary battery module may further include a sensor configured to detect whether at least one of the secondary batteries is swollen, wherein the electrical signal may be applied to the partition member based on a detection result of the sensor.

As an example, the secondary battery module may further include a power supply configured to generate the electrical signal and apply the electrical signal to the electrode plates, wherein the sensor is configured to estimate an extent of the swelling based on at least one of a state of charge and a number of charge-discharge cycles of the at least one of the secondary batteries, the power supply is configured to generate the electrical signal with the magnitude corresponding to the estimated extent of the swelling, and a length of the electrically variable element may be variable in the first direction according to the magnitude of the electrical signal applied to the electrically variable element.

As another example, the secondary battery module may further include a power supply configured to generate the electrical signal and apply the electrical signal to the electrode plates, wherein the sensor is configured to determine an extent the swelling based on a size of the at least one of the secondary batteries in the first direction, the power supply may be configured to generate the electrical signal with the magnitude corresponding to the determined extent of swelling, and a length of the electrically variable element is variable in the first direction according to the magnitude of the electrical signal applied to the electrically variable element.

At least some of the above and other features of the invention are set out in the claims.

### BRIEF DESCRIPTION OF THE DRAWINGS

The drawings appended to the present specification are intended to illustrate embodiments of the present disclosure, and the the present disclosure will be more clearly understood from the accompanying drawings together with the following description of the disclosure, in which:
FIG. 1 is a perspective view of a secondary battery module according to an embodiment of the present disclosure;
FIG. 2 is a perspective view of a secondary battery included in the secondary battery module of FIG. 1;
FIG. 3 is a cross-sectional view of the secondary battery of FIG. 2, taken along a YZ plane;
FIG. 4A is a perspective view of a partition member included in the secondary battery module of FIG. 1;
FIG. 4B is a front view of the partition member of FIG. 4A;
FIG. 5A is a cross-sectional view of the secondary battery module according to an embodiment and illustrates a state in which the secondary batteries do not swell; and
FIG. 5B is a cross-sectional view of another example of the secondary battery module according to an embodiment and illustrates a state in which the secondary batteries are swollen.

### DETAILED DESCRIPTION

Hereinafter, embodiments of the present disclosure will be described in detail with reference to the accompanying drawings. Prior to this, the terms or words used in the present specification and claims should not be construed as being limited to ordinary or dictionary meanings and should be construed as meanings and concepts consistent with the technical disclosure of the present invention based on the principle that an inventor can appropriately define concepts and terms to explain the invention of the inventor in the best way. Therefore, the embodiments described herein and the configuration illustrated in the drawings are only the most preferred embodiments and are not representative of the full technical scope of the present invention, and thus, it should be understood that various equivalents and modifications may be made at the time of filing the present application.

Further, when used in the present specification, "comprise/include" and/or "comprising/including" may specify the presence of described shapes, numbers, steps, operations, members, elements, and/or groups thereof and may not exclude the presence or addition of one or more other shapes, numbers, steps, operations, members, elements, and/or groups thereof.

Further, for helping understand the invention, the accompanying drawings may be illustrated not as actual scales. Rather, sizes of some components may be exaggerated. In addition, the same reference numerals may be assigned to the same components in different embodiments.

The description that two objects for comparison are "the same" as each other may denote that they are "substantially the same" as each other. Thus, the range of the expression "substantially the same" may include a case of having a deviation considered as a low extent, for example, a deviation within 5%. In addition, the description that a certain parameter is the same in a certain region may denote that the parameter is the same from an average perspective.

Terms including ordinals such as first and second may be used to describe various components, but, of course, the components are not limited by the terms. These terms are merely used to distinguish one component from another. Unless particularly described as the opposite, a first component may also be a second component.

Throughout the specification, unless particularly described otherwise, each component may be provided in a singular number or a multiple number.

Arrangement of any configuration on an "upper portion (or lower portion)" of a component or "on (or below)" the component may mean not only any configuration may be disposed to be in contact with an upper surface (or lower surface) of the component but also that another configuration may be interposed between the component and any configuration disposed on (or below) the component.

In addition, when it is described that a component is "connected," "coupled," or "accessed" to another component, these components may be directly connected or accessed to each other, but it should be understood that still another component may be "interposed" between these components, or these components are "connected", "coupled" or "accessed" through still another component.

As used herein, the term "and/or" includes any and all combinations of one or more of the associated listed items. Further, when describing embodiments of the present disclosure, the use of "may" means one or more embodiments of the present disclosure. When preceding a list of elements, the terms "one or more" and "at least one" modify the entire list of elements and do not modify the individual elements of the list.

The expression "A and/or B" throughout the specification means A, B, or A and B, unless otherwise differently stated. The expression "C to D" means C or more and D or less, unless otherwise specified.

When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C.

As used herein, the terms "use," "using," and "used" may be considered synonymous with the terms "utilize," "utilizing," and "utilized," respectively. As used herein, the terms "substantially," "about," and similar terms are used as terms of approximation and not as terms of extent, and are intended to account for the inherent variations in measured or calculated values that would be recognized by those of ordinary skill in the art.

It will be understood that, although the terms first, second, third, and the like may be used herein to describe various elements, components, regions, layers, and/or sections, these elements, components, regions, layers, and/or sections should not be limited by these terms. These terms are used to distinguish one element, component, region, drawing layer, or cross section from another element, component, region, drawing layer, or cross section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the figures. For example, when the device in the drawing is turned over, elements described as "below" or "beneath" other elements would then be oriented "above" or "over" the other elements. Thus, the term "below" may encompass both an orientation of above and below.

The terms used in the present specification are intended to describe embodiments of the present disclosure and are not intended to limit the present disclosure.

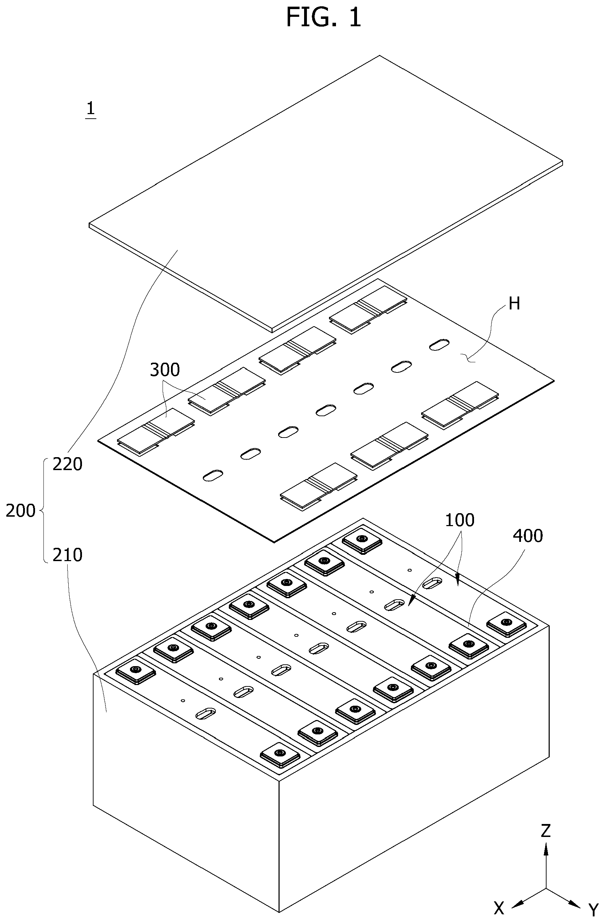

FIG. 1 is a perspective view of a secondary battery module according to an embodiment of the present disclosure. Referring to FIG. 1, a secondary battery module 1 includes a secondary battery 100, a module housing 200, a bus bar 300, and a partition member 400.

A plurality of secondary batteries 100 may be included in the module housing 200. The plurality of secondary batteries 100 may be arranged in a row in either a length direction or a width direction of the module housing 200. In FIG. 1, a case in which eight secondary batteries 100 are arranged in the length direction (an X-axis direction) of the module housing 200 is illustrated as an example, but the arrangement of the plurality of secondary batteries 100 is not limited thereto and may be variously changed. For example, the plurality of secondary batteries 100 may be arranged in a Y-axis (width) direction of the module housing 200, the plurality of secondary batteries 100 arranged in a row in an X-axis direction may be arranged side by side in two or more rows in the Y-axis direction, or the plurality of secondary batteries 100 arranged in a row in the Y-axis direction may be arranged side by side in two or more rows in the X-axis direction. Alternatively, the plurality of secondary batteries 100 arranged in a row in the X-axis direction and/or Y-axis direction and may be stacked and arranged in two or more layers in a Z-axis direction in the module housing 200.

According to the present embodiment, the plurality of secondary batteries 100 are disposed to be spaced apart from each other by a predetermined distance. That is, a predetermined gap exists between adjacent secondary batteries 100. The partition member 400 is disposed in the gap. That is, in the secondary battery module 1 according to the present embodiment, each partition member 400 is disposed in a gap between two secondary batteries 100 that are spaced apart from each other by a predetermined distance. Examples of the partition member 400 will be described below.

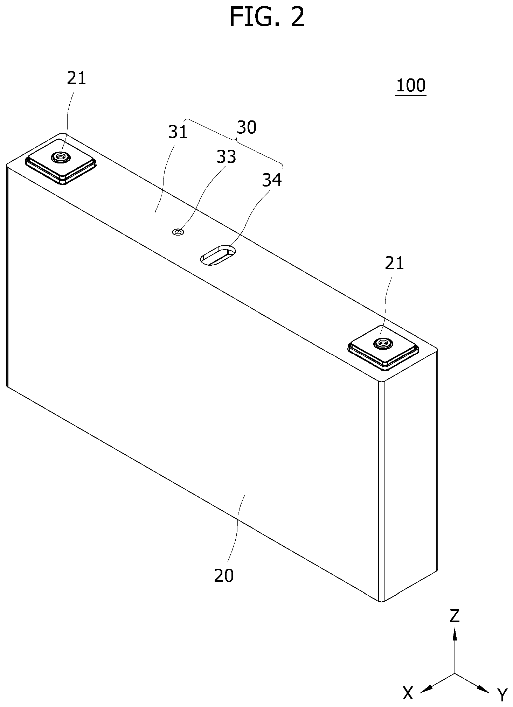

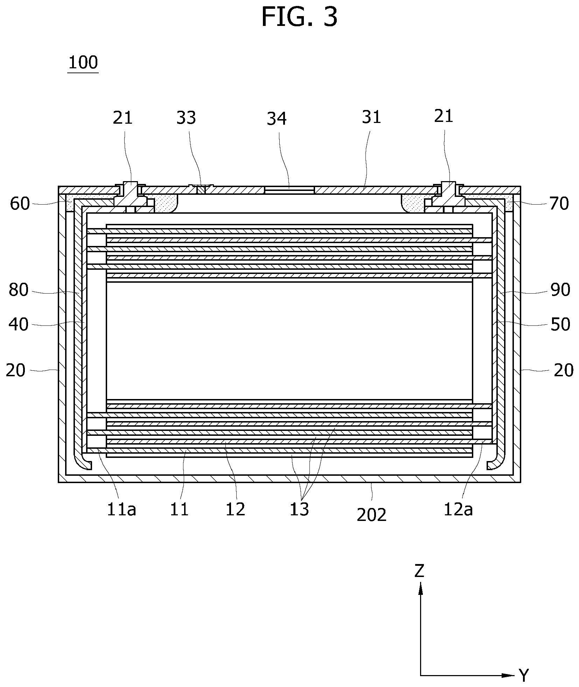

FIG. 2 is a perspective view of a configuration of the secondary battery 100 included in the secondary battery module 1 of FIG. 1. FIG. 3 is a cross-sectional view of the secondary battery 100 of FIG. 2 taken along a YZ plane. The secondary battery 100 shown in FIGS. 2 and 3 is an example of a lithium-ion secondary battery having a prismatic shape. However, the secondary battery 100 of the present disclosure is not limited to the prismatic secondary battery shown in FIG. 2 and FIG. 3 and may be other types or structures of secondary batteries. For example, in embodiments the secondary battery 100 is not a prismatic type and may be a pouch-type or a cylindrical secondary battery.

Referring to FIGS. 2 and 3, the secondary battery 100 includes at least one electrode assembly in which an insulating separator 13 is interposed between a positive electrode 11 and a negative electrode 12, and wound together, a case 20 in which the electrode assembly is accommodated, and a cap assembly 30 coupled to an opening of the case 20. Although not shown in the drawings, the positive electrode 11, the negative electrode 12, and the separator 13 constituting the electrode assembly are impregnated with an electrolyte inside the case 20.

### Positive electrode 11

The positive electrode 11 for the secondary battery 100 may include a current collector and a positive electrode active material layer formed on the current collector. The positive electrode active material layer includes a positive electrode active material and may further include a binder and/or a conductive material. In addition, the positive electrode 11 may further include an additive that can serve as a sacrificial positive electrode.

As the positive electrode active material, a compound (e.g. a lithiated intercalation compound) that is capable of reversible intercalation and deintercalation of lithium may be used. Specifically, one or more of a composite oxide of lithium and a metal selected from cobalt, manganese, nickel, and a combination thereof may be used.

The composite oxide may be a lithium-transition metal composite oxide, and specific examples thereof include lithium nickel-based oxide, lithium cobalt-based oxide, lithium manganese-based oxide, a lithium iron phosphate-based compound, cobalt-free nickel-manganese-based oxide, or a combination thereof. As an example, compounds represented by any one of the following chemical formulas may be used. LiₐA_{1-b}X_{b}O_{2-c}D_{c}(0.90≤a≤1.8, 0≤b≤0.5, 0≤c≤0.05); LiₐMn_{2-b}X_{b}O_{4-c}Dₑ(0.90≤a≤1.8, 0≤b≤0.5, 0≤c≤0.05); LiₐNi_{1-b-c}Co_{b}X_{c}O_{2- α}D_{α}(0.90≤a≤1.8, 0≤b≤0.5, 0≤c≤0.5, 0<α<2); LiₐNi_{1-b-c}Mn_{d}X_{c}O_{2-α}D_{α}(0.90≤a≤1.8, 0≤b≤0.5, 0≤c≤0.5, 0<α<2); LiₐNi_{b}Co_{c}L¹_{d}GₑO₂(0.90≤a≤1.8, 0≤b≤0.9, 0≤c≤0.5, 0≤d≤0.5, 0≤e≤0.1); LiₐNiG_{b}O₂(0.90≤a≤1.8, 0.001≤b≤0.1); LiₐCoG_{b}O₂(0.90≤a≤1.8, 0.001≤b≤0.1); LiₐMn_{1-b}G_{b}O₂(0.90≤a≤1.8, 0.001≤b≤0.1); LiₐMn₂G_{b}O₄(0.90≤a≤1.8, 0.001≤b≤0.1); LiₐMn_{1-g}G_{g}PO₄(0.90≤a≤1.8, 0≤g≤0.5); Li_{(3-f)}Fe₂(PO₄)₃(0≤f≤2); and LiₐFePO₄(0.90≤a≤1.8). In the these chemical formulas, A is Ni, Co, Mn, or a combination thereof; X is Al, Ni, Co, Mn, Cr, Fe, Mg, Sr, V, a rare-earth element or a combination thereof; D is O, F, S, P, or a combination thereof; G is Al, Cr, Mn, Fe, Mg, La, Ce, Sr, V, or a combination thereof; and L¹ is Mn, Al, or a combination thereof.

As an example, the positive electrode active material may be a high-nickel-based positive electrode active material having a nickel content greater than or equal to 80 mol %, greater than or equal to 85 mol %, greater than or equal to 90 mol %, greater than or equal to 91 mol %, or greater than or equal to 94 mol % and less than or equal to 99 mol % based on 100 mol % of the metal in the lithium-transition metal composite oxide excluding lithium. The high-nickel-based positive electrode active material may be capable of realizing high capacity and can be applied to high-capacity and high-density secondary batteries.

An amount of the positive electrode active material may be 90 wt% to 99.5 wt% based on 100 wt% of the positive electrode active material layer, and an amount of each of the binder and the conductive material may be 0.5 wt% to 5 wt% based on 100 wt% of the positive electrode active material layer.

The binder serves to adhere positive electrode active material particles to each other and also to adhere the positive electrode active material to the current collector. Representative examples of the binder include polyvinyl alcohol, carboxylmethyl cellulose, hydroxypropyl cellulose, diacetyl cellulose, polyvinylchloride, carboxylated polyvinylchloride, polyvinylfluoride, an ethylene oxide-containing polymer, polyvinylpyrrolidone, polyurethane, polytetrafluoroethylene, polyvinylidene fluoride, polyethylene, polypropylene, styrene-butadiene rubber, (meth)acrylated styrene-butadiene rubber, an epoxy resin, a (meth)acrylic resin, a polyester resin, nylon, or the like. But the present disclosure is not limited to these examples.

The conductive material is used to provide conductivity to the electrode, and any material that does not cause a chemical change in the battery and is electrically conductive may be used in the battery. Examples of the conductive material include a carbon-based material such as natural graphite, artificial graphite, carbon black, acetylene black, Ketjen black, carbon fibers, carbon nanofibers, carbon nanotubes, and the like, a metal-based material in the form of a metal powder or metal fiber including copper, nickel, aluminum, silver, and the like, a conductive polymer such as a polyphenylene derivative, or a mixture thereof.

Aluminum may be used as the current collector, but the present disclosure is not limited thereto.

### Negative electrode 12

The negative electrode 12 for the secondary battery 100 includes a current collector and a negative electrode active material layer positioned on the current collector. The negative electrode active material layer includes a negative electrode active material and may further include a binder and/or a conductive material. For example, the negative electrode active material layer may include 90 wt% to 99 wt% of the negative electrode active material, 0.5 wt% to 5 wt% of the binder, and 0 wt% to 5 wt% of the conductive material.

The negative electrode active material includes a material that can reversibly intercalate/deintercalate lithium ions, a lithium metal, a lithium metal alloy, a material capable of doping and dedoping lithium, or a transition metal oxide.

The material capable of reversible intercalation and deintercalation of lithium ions is a carbon-based negative electrode active material, and may include, for example, crystalline carbon, amorphous carbon, or a combination thereof. Examples of the crystalline carbon include graphite such as amorphous, plate-shaped, flaky, spherical, or fibrous natural graphite or artificial graphite. Examples of the amorphous carbon include soft carbon or hard carbon, a mesophase pitch carbide product, calcined coke, and the like.

The lithium metal alloy may be an alloy of lithium and a metal selected from Na, K, Rb, Cs, Fr, Be, Mg, Ca, Sr, Si, Sb, Pb, In, Zn, Ba, Ra, Ge, Al, and Sn.

A Si-based negative electrode active material or a Sn-based negative electrode active material may be used as the material capable of doping and dedoping lithium. The Si-based negative electrode active material may include silicon, a silicon-carbon composite, SiOx (0<x<2), a Si-Q alloy, or a combination thereof. In the formula Si-Q, Q is selected from an alkali metal, an alkaline-earth metal, a Group 13 element, a Group 14 element (excluding Si), a Group 15 element, a Group 16 element, a transition metal, a rare-earth element, and a combination thereof. The Sn-based negative electrode active material may include Sn, SnO₂, a Sn-based alloy, or a combination thereof.

The silicon-carbon composite may be a composite of silicon and amorphous carbon. According to an embodiment, the silicon-carbon composite may be in the form of silicon particles and amorphous carbon coated on the surface of the silicon particles. For example, the silicon-carbon composite may include a secondary particle (core) in which silicon primary particles are agglomerated and an amorphous carbon coating layer (shell) positioned on the surface of the secondary particle. The amorphous carbon may also be positioned between the silicon primary particles, such that the silicon primary particles are coated with amorphous carbon. The secondary particles may be dispersed in an amorphous carbon matrix.

The silicon-carbon composite may further include crystalline carbon. For example, the silicon-carbon composite may include a core including crystalline carbon and silicon particles and an amorphous carbon coating layer positioned on the surface of the core.

The Si-based negative electrode active material or the Sn-based negative electrode active material may be used by being mixed with a carbon-based negative electrode active material.

The binder serves to adhere negative electrode active material particles to each other and also to adhere the negative electrode active material to the current collector. As the above binder, a non-aqueous binder, an aqueous binder, a dry binder or a combination thereof may be used.

The non-aqueous binder may include polyvinylchloride, carboxylated polyvinylchloride, polyvinylfluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may be selected from styrene-butadiene rubber, (meth)acrylated styrene-butadiene rubber, (meth)acrylonitrile-butadiene rubber, (meth)acrylic rubber, butyl rubber, a fluoroelastomer, a polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenolic resin, an epoxy resin, polyvinyl alcohol, and a combination thereof.

When the aqueous binder is used as the negative electrode binder, a cellulose-based compound capable of imparting viscosity may be further included. As the cellulose-based compound, one or more of carboxymethyl cellulose, hydroxypropylmethyl cellulose, methyl cellulose, or alkali metal salts thereof may be used in combination. Na, K, or Li can be used as the alkali metal.

The dry binder is a polymer material capable of being fiberized, and may be, for example, polytetrafluoroethylene, polyvinylidene fluoride, a polyvinylidene fluoride-hexafluoropropylene copolymer, a polyethylene oxide, or a combination thereof.

The conductive material is used to provide conductivity to the electrode, and any material that does not cause a chemical change in the battery and is electrically conductive may be used in the battery. Specific examples of the conductive material include a carbon-based material such as natural graphite, artificial graphite, carbon black, acetylene black, Ketjen black, carbon fibers, carbon nanofibers, carbon nanotubes, and the like, a metal-based material in the form of a metal powder or metal fiber including copper, nickel, aluminum, silver, and the like, a conductive polymer such as a polyphenylene derivative, or a mixture thereof.

The negative electrode current collector may be selected from a copper foil, a nickel foil, a stainless steel foil, a titanium foil, a nickel foam, a copper foam, a polymer substrate coated with a conductive metal, and a combination thereof.

### Electrolyte

The electrolyte for the secondary battery 100 includes a non-aqueous organic solvent and a lithium salt.

The non-aqueous organic solvent serves as a medium through which ions taking part in the electrochemical reaction of a battery can move.

The non-aqueous organic solvent may be a carbonate-based, ester-based, ether-based, ketone-based, or alcohol-based solvent, an aprotic solvent, or a combination thereof.

The carbonate-based solvent may include dimethyl carbonate (DMC), diethyl carbonate (DEC), dipropyl carbonate (DPC), methylpropyl carbonate (MPC), ethylpropyl carbonate (EPC), ethylmethyl carbonate (MEC), ethylene carbonate (EC), propylene carbonate (PC), butylene carbonate (BC), and the like.

The ester-based solvent may include methyl acetate, ethyl acetate, n-propyl acetate, dimethyl acetate, methyl propionate, ethyl propionate, decanolide, mevalonolactone, valerolactone, caprolactone, and the like.

The ether-based solvent may include dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone and the like. The alcohol-based solvent may include ethyl alcohol, isopropyl alcohol, and the like, and the aprotic solvent may include nitriles such as R-CN (where R is a C2 to C20 linear, branched, or cyclic hydrocarbon group and includes a double bond, an aromatic ring, or an ether bond), and the like; amides such as dimethyl formamide; dioxolanes such as 1,3-dioxolane and 1,4-dioxolane; sulfolanes; and the like.

The non-aqueous organic solvents may be used alone or in combination of two or more.

In addition, when the carbonate-based solvent is used, a cyclic carbonate and a chain carbonate may be mixed and used, and the cyclic carbonate and the chain carbonate may be mixed in a volume ratio of 1:1 to 1:9.

The lithium salt is a material that is dissolved in the organic solvent and serves as a source of lithium ions in a battery, enables a basic operation of a secondary battery, and improves the movement of the lithium ions between positive and negative electrodes. Representative examples of the lithium salt may include one or two or more selected from among LiPF₆, LiBF₄, LiSbF₆, LiAsF₆, LiClO₄, LiAlO₂, LiAlCl₄, LiPO₂F₂, LiCl, LiI, LiN(SO₃C₂F₅)₂, Li(FSO₂)₂N (lithium bis(fluorosulfonyl)imide, LiFSI), LiC₄F₉SO₃, LiN(CₓF₂ₓ₊₁SO₂)(C_{y}F_{2y+1}SO₂) (where, x and y are integers of 1 to 20), lithium trifluoromethane sulfonate, lithium tetrafluoroethanesulfonate, lithium difluorobis(oxalato)phosphate (LiDFOB), and lithium bis(oxalato) borate (LiBOB).

### Separator 13

Depending on the type of the secondary battery 100, the separator 13 may be present between the positive electrode 11 and the negative electrode 12. The separator 13 may include polyethylene, polypropylene, polyvinylidene fluoride, or a multilayer film of two or more layers thereof. The separator 13 may also include a mixed multilayer film such as a polyethylene/polypropylene two-layer separator, a polyethylene/polypropylene/polyethylene three-layer separator, a polypropylene/polyethylene/polypropylene three-layer separator, or the like.

The separator 13 may include a porous substrate and a coating layer including an organic material, an inorganic material, or a combination thereof positioned on one or both surfaces of the porous substrate.

The porous substrate may be a polymer film formed of a polymer, or a copolymer or a mixture of two or more selected from polyolefins such as polyethylene, polypropylene, and the like, polyesters such as polyethylene terephthalate, polybutylene terephthalate, and the like, polyacetal, polyamide, polyimide, polycarbonate, polyetheretherketone, polyaryletherketone, polyetherimide, polyamideimide, polybenzimidazole, polyether sulfone, a polyphenylene oxide, a cyclic olefin copolymer, polyphenylene sulfide, polyethylene naphthalate, glass fibers, and polytetrafluoroethylene (e.g. Teflon).

The organic material may include a polyvinylidene fluoride-based polymer or a (meth)acrylic-based polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof. But the present disclosure is not limited to these examples.

The organic and inorganic materials may be present by being mixed in one coating layer. Alternatively, the organic and inorganic materials may be present in a form in which a coating layer including organic materials and a coating layer including inorganic materials are stacked.

Referring again to FIGS. 2 and 3, the positive electrode 11 and the negative electrode 12 may each include a coated portion, which is a region in which an active material is coated on a current collector formed of a thin metal foil, and uncoated portions 11a and 12a that are regions to which the active material is not coated.

Each of the positive electrode 11 and the negative electrode 12 has a sheet shape, and a plurality of positive electrodes 11 and a plurality of negative electrodes 12 may be alternately stacked with the separator 13 acting as an insulator being interposed therebetween. However, the present disclosure is not limited thereto. The positive electrode 11 and the negative electrode 12 may also be wound after the separator 13 is interposed therebetween.

The case 20 forms an external shape of the secondary battery 100 and may be formed of a conductive metal such as aluminum, an aluminum alloy, or nickel-plated steel. The case 20 may provide a space in which the electrode assembly is accommodated.

In the prismatic secondary battery 100, the case 20 generally has a rectangular parallelepiped shape. More specifically, the case 20 may include a front surface plate and a rear surface plate facing each other in an X-axis direction, a left side plate and a right side plate facing each other in a Y-axis direction, and a bottom surface plate facing in a Z-axis direction. In addition, an end part in the Z-axis direction may be open. The front surface plate, the rear surface plate, the left side plate, the right side plate, and the bottom surface plate 202 may be formed as separate plate-shaped members and may be joined together at their connecting portions. However, the present disclosure is not limited thereto, and two or more plates may be manufactured by bending a single large-area plate at an angle of 90°.

The cap assembly 30 may include a cap plate 31 that covers an opening of the case 20 at the end part. The case 20 and the cap plate 31 may be made of a conductive material. Here, a terminal 21 electrically connected to the positive electrode 11 or the negative electrode 12 may protrude to outside through the cap plate 31.

The terminal 21 protruding to outside of the cap plate 31 may be formed as a pair. The pair of terminals 21 may be connected to the positive electrode 11 and the negative electrode 12 and may function as a positive electrode terminal and a negative electrode terminal of the secondary battery 100, respectively. The terminals 21 may be electrically connected to current collectors including first and second current collectors 40 and 50 (hereinafter, referred to as positive and negative electrode current collectors) that are joined to a positive electrode uncoated portion 11a and a negative electrode uncoated portion 12a, respectively, by welding. The pair of terminals 21 may be coupled to the positive and negative electrode current collectors 40 and 50 by welding. However, the present disclosure is not limited thereto, and the terminals 21 may be integrally coupled with the positive and negative electrode current collectors 40 and 50.

An outer circumferential surface of an upper column of the terminal 21 may be threaded and may be fixed to the cap plate 31 with a nut. However, the present disclosure is not limited thereto. For example, the terminal 21 may have a rivet structure and may be riveted to the cap plate 31 or welded to the cap plate 31.

The cap plate 31 may be made of a thin plate and coupled to the opening of the case 20. An electrolyte injection hole in which a sealing cap 33 is positioned may be formed in the cap plate 31. A vent 34 may be formed in the cap plate 31.

The vent 34 may be opened and closed as a result of a change in internal pressure of the case 20. That is, the vent 34 may seal the case 20 by maintaining a closed state during normal operation of the electrode assembly. The vent 34 may open as the internal pressure of the case 20 is increased to a set magnitude or more due to, for example overcharge, fire occurrence, or the like. Thus, emissions such as flames and gases may be discharged from the inside of the case 20 through the vent.

An insulating member may be installed between the electrode assembly and the cap plate 31. The insulating member may include first and second lower insulating members 60 and 70, and each of the first and second lower insulating members 60 and 70 may be installed between the electrode assembly and the cap plate 31.

According to the present embodiment, one end of a separation member, which may be installed to face one side surface of the electrode assembly, may be installed between the insulating member and the terminal 21. The separation member may include first and second separation members 80 and 90. Accordingly, ends of the first and second separation members 80 and 90, each of which may face a side surface of the electrode assembly, may be positioned between the first and second lower insulating members 60 and 70 and positive and negative electrode terminals 21, respectively. As a result, the terminals 21 welded to the positive and negative electrode current collectors 40 and 50 may be coupled to the first and second lower insulating members 60 and 70 and ends of first and second separation members 80 and 90, respectively.

The module housing 200 may form an exterior of the secondary battery module 1 and provide a space in which the plurality of secondary batteries 100 can be accommodated. The module housing 200 according to the present disclosure may include a housing body 210 and a cover 220.

The housing body 210 may be formed to have a box shape with a hollow interior and one open side. But the cross-sectional shape of the housing body 210 as viewed in an XY plane is not limited to a quadrangular shape and may be various shapes such as a polygonal shape, a circular shape, and an elliptical shape.

The cover 220 may be coupled to the housing body 210 and may close an internal space of the housing body 210. As an example, the cover 220 may be formed to have a substantially plate shape and may be positioned to face the open side of the housing body 210. The cover 220 may be fixed to the housing body 210 by various types of coupling methods such as bolting, welding, fitting, and the like.

The bus bar 300 electrically connects the plurality of secondary batteries 100 to each other. The bus bar 300 (see Fig. 1) may be disposed between the cover 220 and the secondary batteries 100. A plurality of bus bars 300 may be provided. Each of the bus bars 300 may connect a pair of adjacent secondary batteries 100 in series or parallel. As an example, both sides of the bus bar 300 may be connected to the positive electrode terminal 21 of one of the pair of adjacent secondary batteries 100 and the negative electrode terminal 21 of the other one of the pair of adjacent secondary batteries 100. Accordingly, the plurality of secondary batteries 100 may be connected in series with each other by the bus bar 300. However, the connection form of the bus bar 300 is not limited thereto, and it is also possible that both sides are connected to the positive electrode terminal 21 of one of the pair of adjacent secondary batteries 100 and the positive electrode terminal 21 of the other one of the pair of adjacent secondary batteries 100, or that both sides are connected to the negative electrode terminal 21 of one of the pair of adjacent secondary batteries 100 and the negative electrode terminal 21 of the other one of the pair of adjacent secondary batteries 100, thereby connecting the plurality of secondary batteries 100 in parallel.

The bus bar 300 may be formed of an electrically conductive material, such as copper, aluminum, nickel, or the like. The specific shape of the bus bar 300 is not limited to what is depicted in FIG. 1 and may have forms that can electrically connect the adjacent secondary batteries 100.

The plurality of bus bars 300 may be supported inside the module housing 200 by a bus bar holder H. The bus bar holder H may be formed to have the shape of a flat plate. The bus bar holder H may be disposed between the cover 220 and the secondary batteries 100. The bus bars 300 may be fixed to the bus bar holder H by various types of coupling methods, such as fitting coupling, bolting, injection coupling, and the like. The bus bar holder H may include, for example, a polymer compound material that is electrically insulative.

The partition member 400 is positioned in the gap between the adjacent secondary batteries 100 that are spaced apart by a predetermined distance. For example, as shown in FIGS. 1 to 3, when two secondary batteries 100 are disposed adjacent to each other by positioning the front surface plate of the case 20 of one of the secondary batteries 100 and the rear surface plate of the case 20 of another one of the secondary batteries 100 to face each other with a gap therebetween, the partition member 400 may be positioned in the gap between the front surface plate and the rear surface plate. However, the arrangement position of the partition member 400 is not limited thereto. For example, when the plurality of secondary batteries 100 are arranged in the Y-axis direction, the partition member 400 may be positioned in a gap between the left side plate of the case 20 of one secondary battery 100 and the right side plate of the case 20 of the secondary battery 100 adjacent to the one secondary battery 100.

Although not shown in FIG. 1, the partition member 400 may also be further interposed between the secondary battery 100 and an outer surface plate of the housing body 210 of the module housing. More specifically, the partition member 400 may be further disposed between the secondary batteries 100 disposed at both ends of the plurality of secondary batteries 100 arranged in one direction and a surface of the housing body 210 adjacent to the secondary battery 100. To this end, the plurality of secondary batteries 100 may be arranged in the housing body 210 such that a predetermined gap is provided between the secondary battery 100 and one surface of the housing body 210 of the module housing.

The partition member 400 functions to prevent the propagation of thermal runaway to the adjacent secondary batteries 100 if a thermal event occurs in one secondary battery 100. The partition member 400 may be formed of a material having a higher melting point than that of the case 20 or other components of the secondary battery 100. For example, the partition member 400 may include a member formed of a metallic material with a higher melting point than aluminum (Al) and/or an insulating material such as ceramic.

In addition, the partition member 400 may prevent the secondary battery module 1 from being damaged by absorbing an increase in size of the secondary battery 100 if the secondary battery 100 swells. When the secondary battery 100 is in a normal, non-swollen state, the size (hereinafter referred to as "thickness") of the partition member 400 in the X-axis direction does not change. On the other hand, when the secondary battery 100 swells, the thickness of the partition member 400 may be reduced. Accordingly, even when the secondary battery 100 swells, the overall size of the secondary battery module 1, particularly a length in the X-axis direction, remains unchanged, thereby preventing damage to the cap plate 31, the module housing 200, or the like.

According to the present disclosure, a change in the thickness of the partition member 400 may be induced by using an electrical signal applied thereto. Further, the amount of change in the thickness may also be controlled by adjusting the magnitude of the applied electrical signal. Accordingly, when a swollen state of the secondary battery 100 is detected, preventive measures can be proactively taken to mitigate against a swelling phenomenon of the secondary battery 100 by adjusting the electrical signal applied to the partition member 400 based on the detected swollen state to thereby preemptively change the thickness of the partition member 400. In addition, by preemptively reducing the thickness of the partition member 400 before the swelling secondary battery 100 exerts a pressure on the partition member 400, a pressure applied to the partition member 400 from outside of the secondary battery 100 can be suppressed.

According to the present disclosure, the shape of the partition member 400 is not limited. For example, when the case 20 of the secondary battery 100 has a generally rectangular parallelepiped shape, the partition member 400 may have a hexahedral shape with a rectangular surface that is substantially the same in size and shape as the surface of the case 20 adjacent to the partition member 400. In such a case, the partition member 400 may be in the form of a plate or sheet shape with a predetermined thickness. However, the present disclosure is not limited thereto, and the partition member 400 may be different in size and/or shape from the surface of the case 20 adjacent thereto. In addition, the thickness of the partition member 400 is not particularly limited but may be determined in consideration of the effectiveness of preventing the propagation of thermal runaway, the size of the module housing 200 of the secondary battery module 1, the number of secondary batteries 100 included in the secondary battery module 1, and the like.

According to the present disclosure, the partition member 400 may be a member whose thickness changes in response to an applied electrical signal, i.e., a member with a variable thickness. For example, when a predetermined electrical signal (voltage or current) is applied, the thickness of the partition member 400, i.e., the size in the X-axis direction, may be reduced. In this case, the amount of reduction in the thickness of the partition member 400 may vary depending on the magnitude of the applied electrical signal. For example, the amount of reduction in the thickness of the partition member 400 may be proportional to the magnitude of the applied electrical signal. However, the amount of reduction in thickness and the magnitude of the electrical signal do not necessarily have to be linearly proportional and may exhibit a stepwise proportional relationship or follow a predetermined curve function.

According to one aspect, the partition member 400 may be a variable-volume member having a volume that changes in response to the applied electrical signal. For example, the partition member 400 may be a member that is reduced in overall volume when a predetermined electrical signal (voltage or current) is applied. Accordingly, as the volume of the partition member 400 is reduced, the thickness of the partition member 400 (e.g., the size in the X-axis direction) is also reduced.

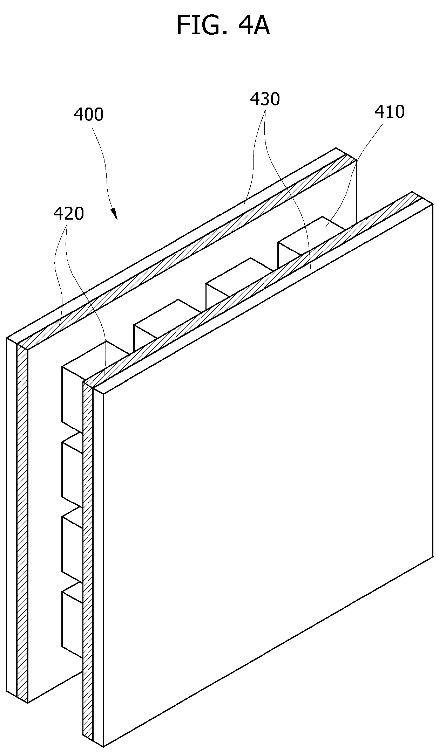

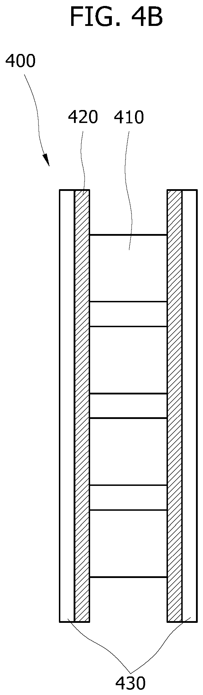

FIG. 4A is a perspective view of an example of the partition member included in the secondary battery module 1 of FIG. 1, and FIG. 4B is a front view of the partition member of FIG. 4A. Referring to FIGS. 4A and 4B, the partition member 400 includes one or more electrically variable elements 410, a pair of electrode members (e.g. electrode plates) 420, and a pair of insulating members (e.g. insulating plates) 430.

The electrically variable elements 410 are configured such that there is a change in at least their thickness in response to an electrical signal applied through a pair of electrode plates 420. In the present disclosure, there is no particular limitation on the type of the electrically variable element 410. The electrically variable element 410 may be formed of a piezoelectric material or an electroactive polymer material. For example, the electrically variable element 410 may include a piezoelectric element and/or an electroactive polymer element. Piezoelectric elements or electroactive polymer elements have the advantage of superior durability compared to elastic elements, such as springs or rubber, which may compress or stretch in response to external pressure.

In the case of a piezoelectric element, when a predetermined voltage is applied to both ends of the piezoelectric element through the pair of electrode plates 420, the reverse piezoelectric effect may cause a volume of the piezoelectric element to decrease or at least a thickness of the piezoelectric element to decrease. Accordingly, the partition member 400 including a piezoelectric element may decrease in size in at least a transverse direction. There is no limitation on the type of piezoelectric element, and piezoelectric elements currently used as well as elements developed and used in the future may be used as long as they exhibit the reverse piezoelectric effect.

In the case of an electroactive polymer element, when a predetermined voltage is applied to both ends of the electroactive polymer element through the pair of electrode plates 420, a volume of the electroactive polymer element may be reduced, or at least a thickness of the electroactive polymer element may be reduced, due to Maxwell forces generated between the electrode plates 420. Accordingly, the partition member 400 including an electroactive polymer element may decrease in size at least in a transverse direction. There is no limitation on the type of electroactive polymer element, and electroactive polymer elements currently used as well as elements developed and used in the future may be used as long as they exhibit the effect of reducing a thickness in an application direction of a voltage due to Maxwell forces and crosslinking reactions between polymers.

The thickness of the electrically variable element 410, i.e., a length in the transverse direction in FIG. 4B, may be set in consideration of the size of the secondary battery 100. In some examples, the thickness of the electrically variable element 410 may range from 0.5 mm to 10 mm. When the thickness of the electrically variable element 410 is less than or equal to 0.5 mm, it becomes difficult to obtain a desired amount of thickness change in the partition member 400 because the amount of thickness change corresponding to the magnitude of the electrical signal is small. When the thickness of the electrically variable element 410 is greater than or equal to 10 mm, the size of the secondary battery 100 increases, which causes the size of the secondary battery module 1 including the plurality of secondary batteries 100 to increase and also reduces the efficiency of space utilization inside the module housing 200.

The electrically variable element 410 may, for example, be in the form of a single plate or sheet with a predetermined thickness. The shape of the electrically variable element 410 (the shape of a cross-sectional plane of the electrically variable element 410 facing the electrode plate 420) may be substantially the same as the shape of the electrode plate 420. In addition, the size of the electrically variable element 410 may be substantially equal to the size of the electrode plate 420. However, the present disclosure is not limited thereto, and the shape or size of the electrically variable element 410 may be different from that of the electrode plate 420.

Alternatively, the electrically variable element 410 may include a plurality of unit electrically variable elements. In such a case, the plurality of unit electrically variable elements may be spaced apart from each other on planes of the pair of electrode plates 420. For example, the plurality of unit electrically variable elements may be distributed and arranged in a grid pattern in a plane that is parallel to the electrode plate 420. When a voltage is applied to the pair of electrode plates 420 and the thickness of the electrically variable element 410 is reduced, the electrically variable element 410 expands in a direction parallel to the plane of the electrode plates 420. When the electrically variable element 410 is formed entirely in a single plate or sheet shape, the amount of expansion of the electrically variable element 410 may not be sufficient, and, thus, the reduction in thickness of the electrically variable element 410 may not be sufficient. But when the electrically variable element 410 includes the plurality of unit electrically variable elements that are spaced apart from each other, there may be sufficient free space for each of the electrically variable elements to expand in a plane direction parallel to the plane of the electrode plate 420 while decreasing in thickness. Thus, it is possible to achieve a greater thickness reduction effect.

The pair of electrode plates 420 function as electrode members for applying an electrical signal to the electrically variable element 410. The pair of electrode plates 420 may be formed of a conductive material. As will be described below, a predetermined power supply (a voltage supply device) may be electrically connected to the pair of electrode plates 420.

The pair of electrode plates 420 may also function as support members that support the electrically variable elements 410. In an embodiment, the pair of electrode plates 420 may be positioned on outer sides of the electrically variable elements 410 in the X-axis direction. The pair of electrode plates 420 are preferably formed of a material with excellent heat resistance. More specifically, the pair of electrode plates 420 may be formed of a material that does not melt and can maintain its structure even during a thermal runaway event. For example, the pair of electrode plates 420 may be formed of a high-melting-point metallic material (i.e., a metallic material having a melting point higher than a melting point of a material of the case 20 of the secondary battery 100) such as stainless steel or an alloy thereof, but the present disclosure is not limited thereto.

The pair of insulating plates 430 function as insulating members to maintain electrical insulation between the adjacent secondary batteries 100. The pair of insulating plates 430 may also function to block or suppress heat transfer between the adjacent secondary batteries 100. Accordingly, even if a thermal runaway event occurs in any one of the secondary batteries 100, the thermal runaway may be suppressed from propagating to the adjacent secondary batteries 100. The pair of insulating plates 430 may be formed of one or more of alumina, mica, and silicone gel. But the present disclosure is not limited to these examples. In an embodiment, the pair of insulating plates 430 may be positioned on outer sides of the pair of electrode plates 420 in the X-axis direction.

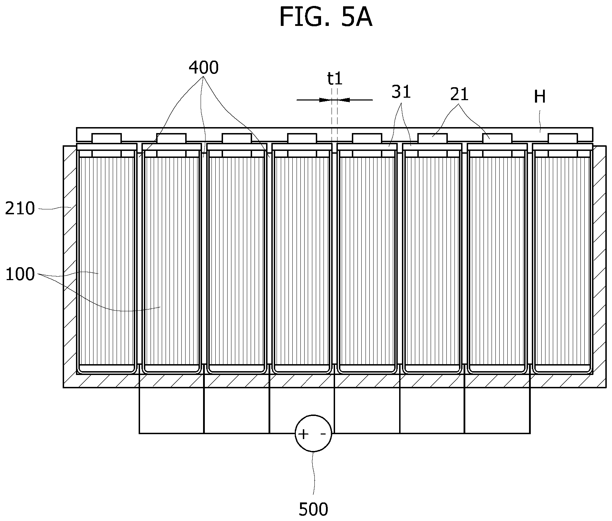

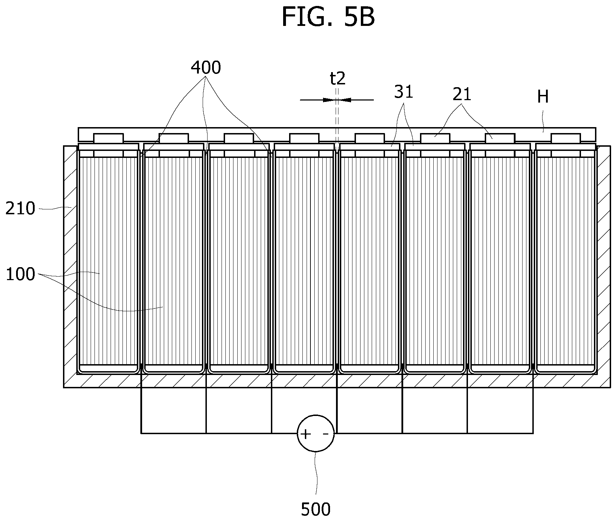

FIGS. 5A and 5B are cross-sectional views schematically illustrating another example of the secondary battery module according to the present disclosure. FIG. 5A illustrates a state in which the secondary batteries 100 do not swell, and FIG. 5B illustrates a state in which the secondary batteries 100 are swollen. Here, the state in which the secondary battery 100 does not swell includes not only a case in which the secondary battery 100 maintains its initial shape and size unchanged, but also a case in which, even though swelling has occurred, the extent of swelling is not great such that changes in shape and/or increases in volume are not great. On the other hand, the state in which the secondary battery 100 swells refers to a case in which the extent of swelling of the secondary battery 100 exceeds a certain level, resulting in a significant change in shape and volume from its initial state.

Swelling may occur in the secondary battery 100 due to various causes depending on its usage. As an example, swelling may occur in the secondary battery 100 depending on a state of charge, and the extent of swelling may be proportional to the state of charge of the secondary battery 100. As another example, swelling may occur in the secondary battery 100 depending on the extent of usage, and the extent of swelling may be proportional to the number of charge-discharge cycles of the secondary battery 100.

Referring to FIGS. 5A and 5B, the secondary battery module according to the present embodiment may further include a voltage application device 500. As described above, the voltage application device 500 is a power supply for applying a predetermined voltage to the partition member 400, more specifically, to the pair of electrode plates 420. In an embodiment, the voltage application device 500 may be a power supply configured to generate the electrical signal and apply the electrical signal to the partition member 400.

There is no limitation on the type or implementation form of the voltage application device 500. For example, the voltage application device 500 may be the same power supply device as that provided in an electrical circuit of the secondary battery module or may be an additional power supply device installed to apply voltage to the partition member 400. In the latter case, the voltage application device 500 may be installed on a printed circuit board (PCB) equipped with an electrical circuit (e.g., a battery management system (BMS)) of the secondary battery module. But the present disclosure is not limited thereto.

The voltage application device 500 does not apply any voltage to the partition member 400 when the secondary battery 100 is not swelling (refer to FIG. 5A). As a result, the partition member 400 retains its initial thickness t1 unchanged. On the other hand, when the secondary battery 100 swells (refer to FIG. 5B), the voltage application device 500 applies a predetermined voltage to the partition member 400. As a result, the partition member 400 is reduced in thickness and has a thickness t2 that is less than the initial thickness t1.

The secondary battery module 1 according to the present disclosure may further include a sensor (not shown) for detecting (e.g. estimating or determining) whether the secondary battery 100 is in a swollen state. In an embodiment, the electrical signal may be applied to the partition member 400 based on a detection result of the sensor. There is no limitation on the type of sensor, and various forms of sensors may be implemented as long as they can estimate or determine the swollen state. In an embodiment, the voltage application device 500 may be configured to generate the electrical signal with a magnitude corresponding to the estimated or determined extent of swelling.

Typically, swelling occurs in the secondary battery 100 in proportion to a state of charge. Accordingly, the sensor may estimate that the secondary battery 100 is in a swollen state when the state of charge of the secondary battery 100 is greater than or equal to a predetermined threshold. According to embodiments, the swollen state may also be estimated based on the overall state of charge of the secondary battery module 1, which includes the plurality of secondary batteries 100.

In addition, swelling may occur in the secondary battery 100 in proportion to the number of charge-discharge cycles. Accordingly, the sensor may estimate that the secondary battery 100 is in the swollen state when the number of charge-discharge cycles of the secondary battery 100 is greater than or equal to a predetermined threshold.

The sensor also may estimate whether the secondary battery 100 is in the swollen state by directly or indirectly measuring the size (the length in the transverse direction of FIGS. 5A and 5B) of the secondary battery 100 or the secondary battery module 1. For example, when the measured size of the secondary battery 100 increases to a value greater than or equal to a predetermined threshold compared to its initial size, the sensor may determine that the secondary battery 100 is swollen.

As described above, in the secondary battery module according to the present disclosure, when the secondary battery 100 swells, a predetermined voltage is applied to the partition member 400 to reduce its thickness. Accordingly, even when the secondary battery 100 swells, the reduction in the thickness of the partition member 400 can prevent or suppress an increase in the overall size of the secondary battery module, particularly the length in the transverse direction in FIG. 5B. As a result, even when the secondary battery 100 swells, pressure can be prevented from being applied to or mitigated on the cap plate 31 and/or a sidewall plate of the module housing 200. Thus, rupture or damage of the structure (such as the cap plate 31 of the secondary battery 100 or the module housing 200) may be prevented or suppressed.

According to an aspect of the present disclosure, the magnitude of the voltage applied to the partition member 400 may vary. For example, the voltage application device 500 may be a variable power supply. That is, the magnitude of the voltage applied from the voltage application device 500 may vary. To this end, the secondary battery module may further include a control unit (not shown) that controls the magnitude of the voltage applied from the voltage application device 500. The control unit may control the magnitude of the voltage applied from the voltage application device 500 based on the extent of swelling of the secondary battery 100. More specifically, the control unit may control the magnitude of the applied voltage to be relatively large when the swelling of the secondary battery 100is significant, and to be relatively small when the swelling of the secondary battery 100 is minor.

The sensor may estimate or determine whether the secondary battery 100 is in the swollen state and also estimate or determine the extent of swelling of the secondary battery 100. For example, the sensor may estimate the extent of swelling based on the state of charge and/or the number of charge-discharge cycles of the secondary battery 100 or determine the extent of swelling based on the measured size of the secondary battery 100 or the secondary battery module 1.

According to an embodiment of the present disclosure, by disposing between adjacent secondary batteries a partition member that can vary in at least thickness in response to an external control signal, it is possible to actively compensate for deformation of the secondary batteries. In particular, by taking into consideration swelling of the secondary battery caused by a state of charge and/or the number of charge/discharge cycles, the likelihood of damage to a module structure, such as a module housing or cap plate, can be preemptively reduced.

However, it will be appreciated by persons skilled in the art that the effects that can be achieved through the present disclosure are not limited to what has been described hereinabove and other advantages of the present disclosure will be more clearly understood from the following detailed description.

While the disclosure has been described with reference to the embodiments illustrated in the accompanying drawings, it should be understood that the disclosure is not limited to the disclosed embodiments, but covers various modifications and equivalent arrangements within the scope of the claims.

## Claims

1. A secondary battery module comprising:
a plurality of secondary batteries arranged in a first direction; and
a partition member positioned in a gap between two adjacent secondary batteries among the plurality of secondary batteries, the partition member having a variable length at least in the first direction in response to an electrical signal applied to the partition member.

2. The secondary battery module of claim 1,
wherein the length of the partition member is variable at least in the first direction according to a magnitude of a voltage of the electrical signal applied to the partition member.

3. The secondary battery module of claim 2, wherein the partition member includes:
one or more electrically variable members each being configured to have a variable length at least in the first direction according to the magnitude of the voltage, and
electrode members configured to apply the voltage to the electrically variable members.

4. The secondary battery module of claim 3, wherein the electrically variable members are configured to change in shape according to the magnitude of the voltage, and
wherein the electrode members are positioned on outer sides of each of the electrically variable members in the first direction.

5. The secondary battery module of claim 4, wherein the electrically variable members are formed of a piezoelectric material or an electroactive polymer material.

6. The secondary battery module of claim 4, wherein the electrode members are each formed of a metallic material having a melting point higher than a melting point of a material of a case of each of the secondary batteries.

7. The secondary battery module of any one of claims 4 to 6, wherein the partition member further includes insulating members positioned on outer sides of the electrode members in the first direction.

8. The secondary battery module of claim 7, wherein the insulating members are each formed of a material that includes one or more of alumina, mica, and silicone gel.

9. The secondary battery module of any one of the preceding claims, further comprising a sensor configured to detect whether at least one of the plurality of secondary batteries is swollen,
wherein the electrical signal is applied to the partition member based on a detection result of the sensor.

10. The secondary battery module of claim 9, further comprising a power supply configured to generate the electrical signal and apply the electrical signal to the partition member,
wherein the sensor is configured to estimate an extent of swelling based on at least one of a state of charge and a number of charge-discharge cycles of the at least one of the secondary batteries,
wherein the power supply is configured to generate the electrical signal with a magnitude corresponding to the estimated extent of swelling, and
wherein the variable length of the partition member is variable in the first direction according to the magnitude of the electrical signal applied to the partition member.

11. The secondary battery module of claim 9, further comprising a power supply configured to generate the electrical signal and apply the electrical signal to the partition member,
wherein the sensor is configured to determine an extent of swelling based on a size of the at least one of the secondary batteries in the first direction,
wherein the power supply is configured to generate the electrical signal with a magnitude corresponding to the determined extent of swelling, and
wherein the variable length of the partition member is variable in the first direction according to the magnitude of the electrical signal applied to the partition member.

12. A secondary battery module comprising:
a plurality of secondary batteries arranged in a first direction; and
a partition member positioned in a gap between two adjacent secondary batteries among the plurality of secondary batteries, the partition having a variable thickness in response to an electrical signal applied to the partition member.
wherein the partition member includes:
an electrically variable element configured to change in size at least in the first direction according to a magnitude of the electrical signal;
electrode plates positioned on outer sides of the electrically variable element in the first direction and configured to apply the electrical signal to the electrically variable element; and
insulating plates positioned on outer sides of the electrode plates in the first direction.

13. The secondary battery module of claim 12, wherein the electrically variable element includes one or more of a piezoelectric element and an electroactive polymer element.

14. The secondary battery module of claim 12 or claim 13, wherein the electrically variable element is a sheet with a thickness in the first direction.

15. The secondary battery module of claim 12, claim 13 or claim 14, wherein the electrically variable element includes a plurality of electrically variable elements, and
wherein the electrically variable elements are spaced from each in a plane that is parallel to the electrode plate.
